# EUROPEAN PATENT SPECIFICATION

(11) **EP 3 572 555 B1**
(45) Date of publication and mention of the grant of the patent: **03.03.2021**
(21) Application number: 18741325.7
(22) Date of filing: 16.01.2018
(51) Int. Cl.: C23C 24/04, H05K 3/10, C23C 24/08

(54) **METHOD FOR MANUFACTURING CERAMIC CIRCUIT BOARD**
VERFAHREN ZUR HERSTELLUNG EINER KERAMISCHEN LEITERPLATTE
PROCÉDÉ DE FABRICATION DE CARTE DE CIRCUIT IMPRIMÉ EN CÉRAMIQUE

(30) Priority: 17.01.2017 JP 2017006090
(43) Date of publication of application: 27.11.2019
(73) Proprietor: Shinshu University, Matsumoto City, Nagano 390-8621 (JP); Denka Company Limited, Tokyo 103-8338 (JP)
(72) Inventor: SAKAKI Kazuhiko, Nagano City Nagano 380-8553 (JP); SAKAI Atsushi, Omuta-city, Fukuoka 836-8510 (JP); YAMADA Suzuya, Chuo-ku Tokyo 103-8338 (JP); TANIGUCHI Yoshitaka, Omuta-city Fukuoka 836-8510 (JP)
(74) Representative: Gulde & Partner
(86) International application number: PCT/JP2018/001054
(87) International publication number: WO 2018/135499

(56) References cited:
- EP-A1- 2 732 967
- WO-A1-2016/056567
- JP-A- 2006 089 290
- JP-A- 2012 153 581
- JP-A- 2013 067 825
- US-A1- 2004 101 620
- US-A1- 2006 063 024

## Description

### Technical Field

The present invention relates to a method for producing a ceramic circuit board.

### Background Art

For semiconductor devices to be utilized in power modules and the like, ceramic circuit boards including a ceramic substrate such as alumina and a conductive circuit layer formed on the front and back sides of the ceramic substrate has been put to practical use. Copper is generally used as a circuit material for ceramic circuit boards.

In recent years, the amount of heat generated from semiconductor devices tends to increase in association with the miniaturization and advancement of performance of machinery. For this reason, the ceramic substrate for ceramic circuit board is required to exhibit higher thermal conductivity in addition to high electrical insulating properties.

Hence, the application of highly thermal conductive ceramic substrates such as aluminum nitride has been examined. However, in a case in which a copper circuit is provided on a highly thermal conductive ceramic substrate, there is a problem that a crack is easily generated in the vicinity of the bonding portion between the ceramic substrate and the copper circuit by the influence of repeated thermal cycles involved in the operation of semiconductor devices or temperature changes in the operating environment.

In order to avoid this problem, it has been investigated to use aluminum exhibiting lower yield resistance than copper as a circuit material. As a method for forming an aluminum circuit on a ceramic substrate, for example, the following methods have been proposed.
(1) A molten metal method including bringing molten aluminum into contact with a ceramic substrate and cooling these to form a bonded body thereof, performing mechanical grinding of the formed aluminum layer to adjust the thickness, and etching the aluminum layer (see, for example, Patent Literatures 1 and 2).
(2) A brazing method in which an aluminum foil or aluminum alloy foil is brazed to a ceramic substrate and then etched (see, for example, Patent Literature 3).

JP 2012 153581 A describes a method for joining ceramics and aluminum that can provide thermal cycle fatigue characteristics while joining a ceramic substrate and an aluminum alloy or the like with enough strength. The method comprises a step of forming an aluminum film on a ceramic substrate by ejecting a working gas heated to 200 to 400 °C and aluminum powder from a nozzle of a spray gun and colliding with the ceramic substrate, and a step of brazing aluminum or an aluminum alloy, and selecting a joining method of ceramics and aluminum.

US 2004/101620 A1 discloses aluminum metallization of ceramics using a kinetic spray system.

US 2006/063024 A1 describes a metallized substrate that has little warping and a fine, smooth surface. In the metallized substrate, a conductive film is formed by spraying on the surface of a ceramic substrate or composite substrate of a ceramic and a metal.

### Citation List

### Patent Literature

Patent Literature 1: Japanese Unexamined Patent Publication No. H7-193358
Patent Literature 2: Japanese Unexamined Patent Publication No. H8-208359
Patent Literature 3: Japanese Unexamined Patent Publication No. 2001-085808

### Summary of Invention

### Technical Problem

However, the molten metal method requires great cost for the facility and the maintenance thereof. In addition, it is difficult to improve the productivity by the brazing method since the brazing method involves pressurization at a high temperature and the like.

An object of the present invention is to provide a method by which a ceramic circuit board including a metal layer which contains aluminum and/or an aluminum alloy as a main component and exhibits high adhesion to a ceramic substrate can be efficiently produced using a simple facility.

### Solution to Problem

An aspect of the present invention relates to a method for producing a ceramic circuit board which includes a ceramic substrate and a metal layer which is formed on the ceramic substrate and contains aluminum and/or an aluminum alloy. The method includes a step of forming the metal layer in contact with the ceramic substrate by spraying a metal powder after accelerating the metal powder to a velocity of from 250 to 1050 m/s as well as heating the metal powder to from 10°C to 270°C and a step of subjecting the ceramic substrate and the metal layer formed on the ceramic substrate to a heat treatment in an inert gas atmosphere. The metal powder contains at least either of aluminum particles or aluminum alloy particles. The ceramic substrate and the metal layer are heated to from 400°C to 600°C in the step of subjecting the ceramic substrate and the metal layer to a heat treatment in an inert gas atmosphere.

According to this method, it is possible to efficiently produce a ceramic circuit board including a metal layer which contains aluminum and/or an aluminum alloy as a main component and exhibits high adhesion to a ceramic substrate using a simple facility. In particular, a method for depositing a metal layer by spraying a metal powder in a solid phase at a high velocity can be referred to as a cold spray method, and it is possible to efficiently deposit a metal layer exhibiting high adhesion to a ceramic substrate using a simple facility according to this method.

### Advantageous Effects of Invention

According to the method according to an aspect of the present invention, it is possible to produce an aluminum circuit board by bonding a metal layer containing aluminum or an aluminum alloy as a main component with a ceramic substrate without necessarily requiring molten aluminum and a brazing material. In addition, it is possible to form a metal layer having a wiring pattern on a ceramic substrate without requiring etching by using a mask when the metal layer is formed.

### Brief Description of Drawings

FIG. 1 is a cross-sectional view illustrating an embodiment of a ceramic circuit board.
FIG. 2 is a schematic view illustrating an embodiment of a step of forming a metal layer on a ceramic substrate.
FIG. 3 is a cross-sectional view illustrating an embodiment of a ceramic circuit board.
FIG. 4 is a schematic view for describing a method for measuring adhesive strength.
FIG. 5 is a graph showing the measurement results on adhesive strength.
FIG. 6 is a cross-sectional view illustrating a fracture position of a test piece in the measurement of adhesive strength.

### Description of Embodiments

Hereinafter, several embodiments of the present invention will be described in detail. However, the present invention is not limited to the following embodiments.

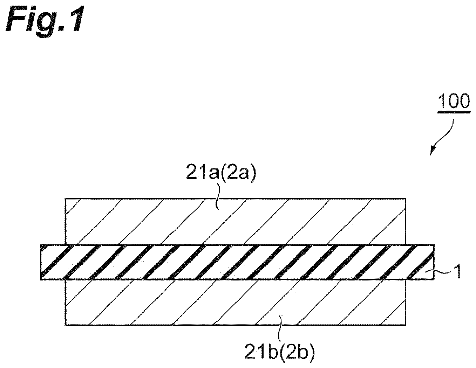

A method according to an embodiment relates to a method for producing a ceramic circuit board including a metal layer containing aluminum and/or an aluminum alloy. FIG. 1 is a cross-sectional view illustrating an embodiment of a ceramic circuit board to be produced. A ceramic circuit board 100 illustrated in FIG. 1 includes a ceramic substrate 1 and metal layers 2a and 2b provided on the ceramic substrate 1 while being in contact with both sides thereof. The metal layers 2a and 2b illustrated in FIG. 1 are formed of a single metal layer 21a and a single metal layer 21b, respectively. The metal layers 2a and 2b are layers formed by spraying a heated metal powder onto the surface of a ceramic substrate and often have a circuit pattern to be connected to a semiconductor device.

The metal layers 2a and 2b contain at least either of aluminum or an aluminum alloy as a main component. Here, the "main component" means a component contained at a proportion of 90% by mass or more based on the entire mass of the metal layers 2a and 2b. In a case in which the metal layer contains both aluminum and an aluminum alloy, the entire amount thereof may be 90% by mass or more. The proportion of the main component may be 95% by mass or more. The metal layers or metal particles to be described later may contain unavoidable impurities in a trace amount.

The method according to the present embodiment includes a step of forming the metal layer on the ceramic substrate by spraying a metal powder composed of a plurality of metal particles after accelerating the metal powder to a velocity of from 250 to 1050 m/s as well as heating the metal powder to from 10°C to 270°C and a step of subjecting the ceramic substrate and the metal layer formed on the ceramic substrate to a heat treatment in an inert gas atmosphere. As aluminum particles and/or aluminum alloy particles are used as the metal particles constituting the metal powder, a metal layer containing these as a main component is formed.

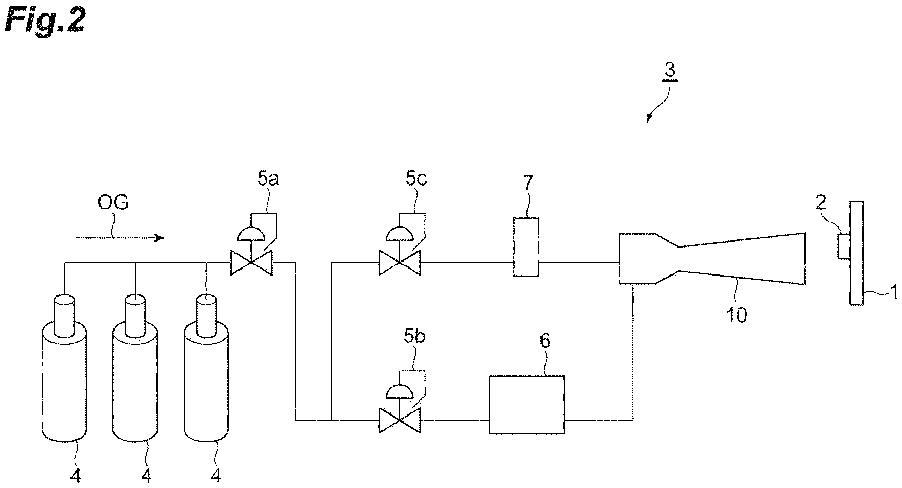

FIG. 2 is a schematic view illustrating an embodiment of a step of forming a metal layer on a ceramic substrate. In the method illustrated in FIG. 2, a metal layer 2 is deposited on the ceramic substrate 1 by spraying the metal powder onto the ceramic substrate 1 using a cold spray apparatus 3. The cold spray apparatus 3 illustrated in FIG. 2 mainly includes high pressure gas cylinders 4, a heater 6, a powder supply apparatus 7, a nozzle 10 of a convergent-divergent spray gun, and pipes connecting these. A first pressure regulator 5a is provided on the downstream side of the plurality of high pressure gas cylinders 4, and the pipe branches into two ways on the downstream side of the first pressure regulator 5a. A second pressure regulator 5b and the heater 6 and a third pressure regulator 5c and the powder supply apparatus 7 are respectively connected to each of the pipes branched into two ways. The pipes from the heater 6 and the powder supply apparatus 7 are connected to the nozzle 10.

In the cold spray apparatus 3, the high pressure gas cylinders 4 are filled with an inert gas to be used as a working gas at a pressure of, for example, 1 MPa or more. The inert gas can be, for example, a single gas of helium or nitrogen or a mixed gas thereof. The working gas OG supplied from the high pressure gas cylinders 4 is decompressed, for example, from 0.5 to 5 Ma by the second pressure regulator 5b on one way, then heated by the heater 6, and then supplied to the nozzle 10 of the spray gun. The working gas OG is also decompressed to, for example, from 0.5 to 5 Ma by the third pressure regulator 5c on the other way and then supplied to the powder supply apparatus 7. The metal powder for deposition is supplied from the powder supply apparatus 7 to the nozzle 10 of the spray gun together with the working gas OG.

The heating temperature by the heater 6 is typically set to be lower than the melting point or softening point of the metal powder to be deposited. The heater 6 can be arbitrarily selected from usual heating apparatuses.

The working gas supplied to the nozzle 10 of the spray gun is compressed by passing through the convergent part and is accelerated by expanding at a time at the divergent part on the downstream side thereof. The metal powder is accelerated to a predetermined velocity as well as heated to a predetermined temperature and then ejected through the outlet of the nozzle 10. Specifically, the metal powder is accelerated to a velocity of from 250 to 1050 m/s as well as heated to from 10°C to 270°C. Here, the temperature to which the metal powder is heated means the maximum temperature of the metal powder reached. The temperature of the inert gas at the inlet of the nozzle 10 can also be regarded as the temperature to which the metal powder is heated. Here, the term "heating" in the present specification is used in the meaning including adjusting the temperature to a predetermined temperature equal to or less than room temperature. In addition, the velocity to which the metal powder is accelerated means the maximum velocity which the accelerated metal powder reaches.

The metal powder ejected from the nozzle 10 is sprayed onto the surface of the ceramic substrate 1. By this, the metal powder is deposited on the ceramic substrate 1 while colliding with the surface thereof in a solid state, and the metal layer 2 is thus formed. The temperature of the metal powder can be typically changed in association with the expansion of the working gas in the nozzle 10 and the like.

The metal powder are mainly composed of aluminum particles and/or aluminum alloy particles. When these are heated to a temperature higher than 270°C, the softened aluminum particles or aluminum alloy particles adhere to the inner wall of the nozzle 10, as a result, the nozzle is clogged, and it is difficult to form the metal layer in some cases. In addition, when the temperature of the metal powder is less than 10°C, it is difficult for the metal particles to be sufficiently plastically deformed at the moment at which the metal powder collides with the ceramic substrate, and there is thus a tendency that it is difficult to perform deposition. From the same viewpoint, the temperature to which the metal powder is heated may be 260°C or less and may be 20°C or more.

When the velocity which the accelerated metal powder reaches is less than 250 m/s, it is difficult for the metal powder to be sufficiently plastically deformed when the metal powder collides with the ceramic substrate, and there is thus a tendency that it is difficult to perform deposition or the adhesion of the deposited metal layer deteriorates. When the velocity which the accelerated metal powder reaches exceeds 1050 m/s, the metal powder is pulverized and scattered when the metal powder collides with the ceramic substrate and there is thus a tendency that it is difficult to perform deposition. From the same viewpoint, the velocity which the accelerated metal powder reaches may be 300 m/s or more and may be 1000 m/s or less.

In order to suppress the formation of pores in the metal layer, the metal particles in the metal powder may be spherical. In addition, the variation in particle diameter of the metal powder may be small. The (average) particle diameter of the metal particles constituting the metal powder may be from 10 to 70 µm or from 20 to 60 µm. When the particle diameter of the metal particles is less than 10 µm, the metal powder tends to easily clog at the convergent part of the nozzle. When the particle diameter of the metal particles exceeds 70 µm, it tends to be difficult to sufficiently increase the velocity of the metal powder. Here, the "particle diameter" means the maximum width of each particle. The particle diameter of a sufficient number of metal particles can be measured, and the average particle diameter can be determined from the result.

The metal powder may be aluminum particles or aluminum alloy particles containing other metal elements such as aluminum-magnesium alloy particles and aluminum-lithium alloy particles. When aluminum alloy particles containing metal elements such as magnesium and lithium exhibiting higher affinity for oxygen than aluminum, there is a tendency that the metal element such as magnesium or lithium reacts with aluminum and the oxide layer on the surface of the ceramic substrate and these firmly bond with each other at the time of heat treatment after deposition. From the viewpoint of the proper hardness of metal layer and the heat cycle resistance, the content of the metal elements such as magnesium and lithium in the metal powder or metal particles may be 6.0% by mass or less with respect to the mass of the metal powder or metal particles.

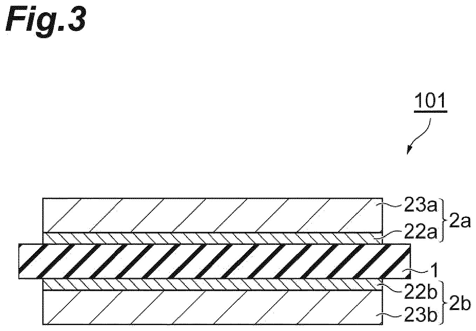

FIG. 3 is a cross-sectional view illustrating another embodiment of a ceramic circuit board to be produced. In a ceramic circuit board 101 of FIG. 3, the metal layers 2a and 2b are respectively composed of first metal layers 22a and 22b in contact with the ceramic substrate and second metal layer 23a and 23b formed on the first metal layers 22a and 22b. In a case in which the metal layer has the first metal layer and the second metal layer in this manner, the metal layer can be formed, for example, by a method including forming a first metal layer on a ceramic substrate by spraying aluminum alloy particles onto the ceramic substrate and forming a second metal layer on the first metal layer by spraying aluminum particles onto the first metal layer. In this case, the aluminum alloy particles for the formation of the first metal layer and the aluminum particles for the formation of the second metal layer may be accelerated to a velocity of from 250 to 1050 m/s as well as heated to from 10°C to 270°C.

A metal layer having a pattern (circuit pattern) may be formed on the ceramic substrate 1 by disposing a mask material covering a part of the surface of the ceramic substrate 1 on the ceramic substrate 1. According to this method, it is possible to easily form a metal layer having a desired pattern without requiring an additional step such as etching after deposition. In this respect as well, the method according to the present embodiment is advantageous over the molten metal method and brazing method which require etching for pattern formation.

The thickness of the metal layer is not particularly limited but may be, for example, from 200 to 600 µm. In a case in which the metal layer has a first metal layer and a second metal layer, the thickness of the second metal layer may be thinner than the thickness of the first metal layer. In particular, in a case in which the first metal layer is formed using aluminum-magnesium alloy particles, the thickness of the first metal layer may be 200 µm or less or 100 µm or less in order to diminish the influence of the stress generated at the interface between the ceramic substrate and the first metal layer on the heat cycle resistance.

In the heat treatment after the formation of the metal layer, the ceramic substrate and the metal layer are heated to from 400°C to 600°C. As this heating temperature is 400°C or more, there is a tendency that the aluminum and the oxide layer on the surface of the ceramic substrate react with each other and thus the ceramic substrate and the metal layer more firmly bond with each other. As the heating temperature is 600°C or less, the influence of the softening of the metal layer can be diminished.

The ceramic substrate can be selected from those exhibiting proper insulating properties. The ceramic substrate may exhibit high thermal conductivity. Examples of the ceramic substrate include an aluminum nitride (AlN) substrate, a silicon nitride (Si₃N₄) substrate, and aluminum oxide (Al₂O₃). The aluminum nitride substrate may exhibit a three-point bending strength of 400 MPa or more and/or a thermal conductivity of 150 W/mK or more. The silicon nitride substrate may exhibit a three-point bending strength of 600 MPa or more and/or a thermal conductivity of 50 W/mK or more. The size of the ceramic substrate 1 is arbitrarily set according to the application. The thickness of the ceramic substrate 1 is not particularly limited but may be, for example, from 0.2 to 1.0 mm. These ceramic substrates can be respectively procured as commercial products.

### EXAMPLES

Hereinafter, the present invention will be more specifically described with reference to Examples. However, the present invention is not limited to these Examples.

### Ceramic substrate

In all Examples and all Comparative Examples, an aluminum nitride (AIN) substrate (size: 10 mm × 10 mm × 0.635 mm t, three-point bending strength: 500 MPa, thermal conductivity: 150 W/mK, and purity: 95% or more) or a silicon nitride (Si₃N₄) substrate (size: 10 mm × 10 mm × 0.635 mm t, three-point bending strength: 700 MPa, thermal conductivity: 70 W/mK, and purity: 92% or more) was used.

### Example 1

A part of the surface of the aluminum nitride substrate was masked with an iron mask material. A metal layer having a length of 3 mm, a width of 3 mm, and a thickness of 300 µm was formed thereon by a cold spray method using aluminum powder (water atomized powder manufactured by Toyo Aluminium K.K., purity: 99.7%, particle size: 45 µm or less). The deposition by the cold spray method was performed using nitrogen as a working gas under the conditions in which the temperature of powder was set to 20°C and the velocity of powder was set to 300 m/s.

The aluminum nitride substrate on which the metal layer was formed was maintained at 500°C for 3 hours in a nitrogen atmosphere for a heat treatment.

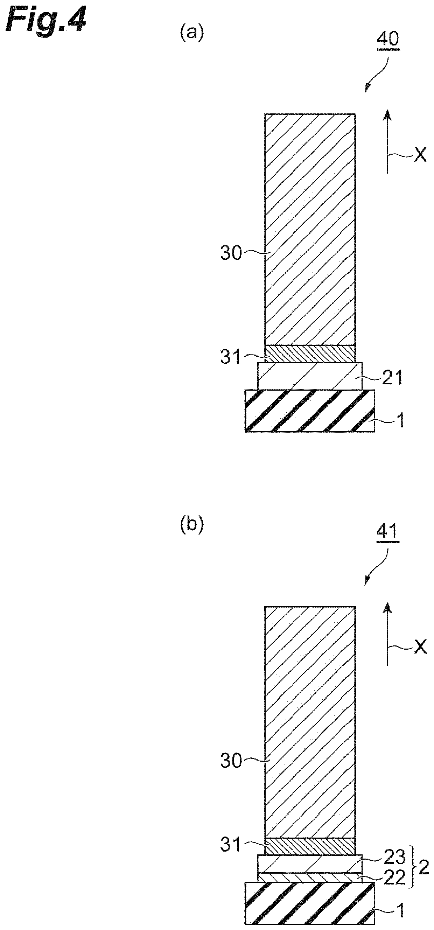

After the heat treatment, a test piece illustrated in FIG. 4(a) was fabricated. A test piece 40 illustrated in FIG. 4(a) has a configuration in which a cylindrical stud pin 30 (material: aluminum, size: φ2.7 mm × 12.7 mm) is bonded to the metal layer 21 on the ceramic substrate 1 via an epoxy adhesive 31 provided on one end of the cylindrical stud pin 30. The test piece 40 was prepared by disposing the stud pin 30 on the metal layer 21 while interposing the epoxy adhesive 31 therebetween and curing the epoxy adhesive 31 by a heat treatment at 150°C for 1 hour in this state.

### Examples 2 to 6

Test pieces were obtained in the same manner as in Example 1 except that the ceramic substrate and the temperature and velocity of aluminum powder in cold spray were changed as presented in Table 1.

### Example 7

A part of the surface of the silicon nitride substrate was masked with an iron mask material. A first metal layer having a length of 3 mm, a width of 3 mm, and a thickness of 100 µm was formed thereon by a cold spray method using aluminum-magnesium alloy powder (gas atomized powder manufactured by Kojundo Chemical Laboratory Co., Ltd., magnesium content: 3.0% by mass, content of impurities other than aluminum and magnesium: 0.1% by mass or less, particle diameter: 45 µm or less). The deposition by the cold spray method was performed using nitrogen as a working gas under the conditions in which the temperature of powder was set to 20°C and the velocity of powder was set to 300 m/s.

A second metal layer having a length of 3 mm, a width of 3 mm, and a thickness of 200 µm was formed on the first metal layer using aluminum powder (water atomized powder manufactured by Toyo Aluminium K.K., purity: 99.7%, particle diameter: 45 µm or less) by a cold spray method (working gas: nitrogen, temperature of powder: 20°C, velocity of powder: 300 m/s) under the same conditions as for the first metal layer.

The aluminum nitride substrate on which the first metal layer and the second metal layer were formed was maintained at 500°C for 3 hours in a nitrogen atmosphere for a heat treatment.

After the heat treatment, a test piece illustrated in FIG. 4(b) was fabricated. A test piece 41 illustrated in FIG. 4(b) has a configuration in which the cylindrical stud pin 30 (material: aluminum, size: φ2.7 mm × 12.7 mm) is bonded to the metal layer 2 composed of the first metal layer 22 and the second metal layer 23 on the ceramic substrate 1 via the epoxy adhesive 31 provided on one end of the cylindrical stud pin 30. The test piece 41 was prepared by disposing the stud pin 30 on the second metal layer 23 while interposing the epoxy adhesive 31 therebetween and curing the epoxy adhesive 31 by a heat treatment at 150°C for 1 hour in this state.

### Examples 8 to 18

Test pieces for adhesive strength measurement were obtained in the same manner as in Example 7 except that the ceramic substrate, the metal powder for the formation of the first metal layer, and the temperature and velocity of powder in cold spray were changed as presented in Table 1. In Examples 13 to 18, aluminum-magnesium alloy powder (gas atomized powder manufactured by Kojundo Chemical Laboratory Co., Ltd., magnesium content: 6.0% by mass, content of impurities other than aluminum and magnesium: 0.1% by mass or less, particle diameter: 45 µm or less) was used for the formation of the first metal layer.

### Comparative Examples 1 to 22

Test pieces for adhesive strength measurement were fabricated in the same manner as in Example 1 or 7 except that the ceramic substrate, the metal powder for the formation of the first metal layer, and the temperature and velocity of powder in cold spray were changed as presented in Table 2.

However, the aluminum powder was not attached to the aluminum nitride substrate and it was not able to form the first metal layer in Comparative Examples 7, 8, 11, and 12 in which the temperature of powder in the cold spray method for the formation of the first metal layer was set to 0°C and Comparative Examples 15 to 22 in which the velocity of powder was set to 200 m/s or 1100 m/s. In Comparative Examples 9, 10, 13, and 14 in which the temperature of powder in the cold spray method for the formation of the first metal layer was set to 280°C, clogging of the aluminum powder occurred in the nozzle and thus it was not able to form the first metal layer.

**Table 1**

| Ex. | Subst rate | Cold spray | | (First) metal layer | | Second metal layer | | Heat treat ment | Success or failure of deposition |
|---|---|---|---|---|---|---|---|---|---|
| | | Temp. (°C) | Vel. (m/s) | Kind of metal | Thick ness (µm) | Kind of metal | Thick ness (µm) | | |
| 1 | AlN | 20 | 300 | Al | 300 | - | - | With | Success |
| 2 | Si₃N₄ | 260 | 300 | Al | 300 | - | - | With | Success |
| 3 | Si₃N₄ | 20 | 650 | Al | 300 | - | - | With | Success |
| 4 | AlN | 260 | 650 | Al | 300 | - | - | With | Success |
| 5 | Si₃N₄ | 20 | 1000 | Al | 300 | - | - | With | Success |
| 6 | AlN | 260 | 1000 | Al | 300 | - | - | With | Success |
| 7 | Si₃N₄ | 20 | 300 | Al-Mg (3.0 wt%) | 100 | Al | 200 | With | Success |
| 8 | AlN | 260 | 300 | Al-Mg (3.0 wt%) | 100 | Al | 200 | With | Success |
| 9 | AlN | 20 | 650 | Al-Mg (3.0 wt%) | 100 | Al | 200 | With | Success |
| 10 | Si₃N₄ | 260 | 650 | Al-Mg (3.0 wt%) | 100 | Al | 200 | With | Success |
| 11 | AlN | 20 | 1000 | Al-Mg (3.0 wt%) | 100 | Al | 200 | With | Success |
| 12 | Si₃N₄ | 260 | 1000 | Al-Mg (3.0 wt%) | 100 | Al | 200 | With | Success |
| 13 | AlN | 20 | 300 | Al-Mg (6.0 wt%) | 100 | Al | 200 | With | Success |
| 14 | Si₃N₄ | 260 | 300 | Al-Mg (6.0 wt%) | 100 | Al | 200 | With | Success |
| 15 | Si₃N₄ | 20 | 650 | Al-Mg (6.0 wt%) | 100 | Al | 200 | With | Success |
| 16 | AlN | 260 | 650 | Al-Mg (6.0 wt%) | 100 | Al | 200 | With | Success |
| 17 | Si₃N₄ | 20 | 1000 | Al-Mg (6.0 wt%) | 100 | Al | 200 | With | Success |
| 18 | AlN | 260 | 1000 | Al-Mg (6.0 wt%) | 100 | Al | 200 | With | Success |

**Table 2**

| Comp. Ex. | Subst rate | Cold spray | | (First) metal layer | | Second metal layer | | Heat treatmen t | Success or failure of depositi on |
|---|---|---|---|---|---|---|---|---|---|
| | | Temp. (°C) | Vel. (m/s) | Kind of metal | Thick ness (µm) | Kind of metal | Thick ness (µm) | | |
| 1 | AlN | 20 | 300 | Al | 300 | - | - | Without | Success |
| 2 | AlN | 260 | 1000 | Al | 300 | - | - | Without | Success |
| 3 | Si₃N₄ | 20 | 300 | Al-Mg (3.0 wt%) | 100 | Al | 200 | Without | Success |
| 4 | Si₃N₄ | 260 | 1000 | Al-Mg (3.0 wt%) | 100 | Al | 200 | Without | Success |
| 5 | AlN | 20 | 300 | Al-Mg (6.0 wt%) | 100 | Al | 200 | Without | Success |
| 6 | AlN | 260 | 1000 | Al-Mg (6.0 wt%) | 100 | Al | 200 | Without | Success |
| 7 | AlN | 0 | 300 | Al | - | - | - | - | Failure |
| 8 | AlN | 0 | 1000 | Al | - | - | - | - | Failure |
| 9 | AlN | 280 | 300 | Al | - | - | - | - | Failure |
| 10 | AlN | 280 | 1000 | Al | - | - | - | - | Failure |
| 11 | AlN | 0 | 300 | Al-Mg (6.0 wt%) | - | - | - | - | Failure |
| 12 | AlN | 0 | 1000 | Al-Mg (6.0 wt%) | - | - | - | - | Failure |
| 13 | AlN | 280 | 300 | Al-Mg (6.0 wt%) | - | - | - | - | Failure |
| 14 | AlN | 280 | 1000 | Al-Mg (6.0 wt%) | - | - | - | - | Failure |
| 15 | AlN | 20 | 200 | Al | - | - | - | - | Failure |
| 16 | AlN | 260 | 200 | Al | - | - | - | - | Failure |
| 17 | AlN | 20 | 1100 | Al | - | - | - | - | Failure |
| 18 | AlN | 260 | 1100 | Al | - | - | - | - | Failure |
| 19 | AlN | 20 | 200 | Al-Mg (6.0 wt%) | - | - | - | - | Failure |
| 20 | AlN | 260 | 200 | Al-Mg (6.0 wt%) | - | - | - | - | Failure |
| 21 | AlN | 20 | 1100 | Al-Mg (6.0 wt%) | - | - | - | - | Failure |
| 22 | AlN | 260 | 1100 | Al-Mg (6.0 wt%) | - | - | - | - | Failure |

### Adhesive strength test

Examples 1 to 18 and Comparative Examples 1 to 6 in which test pieces were obtained were subjected to a test to apply a tensile load in the direction X of FIG. 4, and the load when the test piece was fractured was measured. The adhesive strength was calculated from this load and the cross-sectional area of the fracture position.

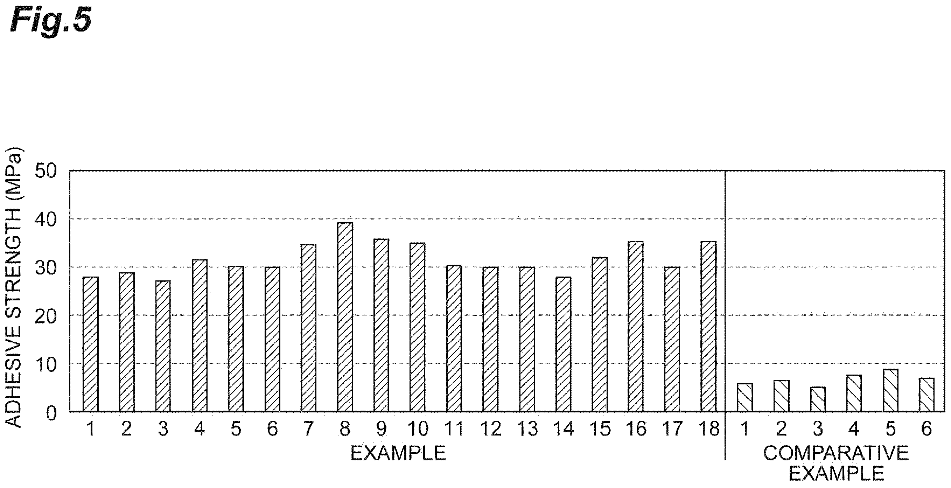

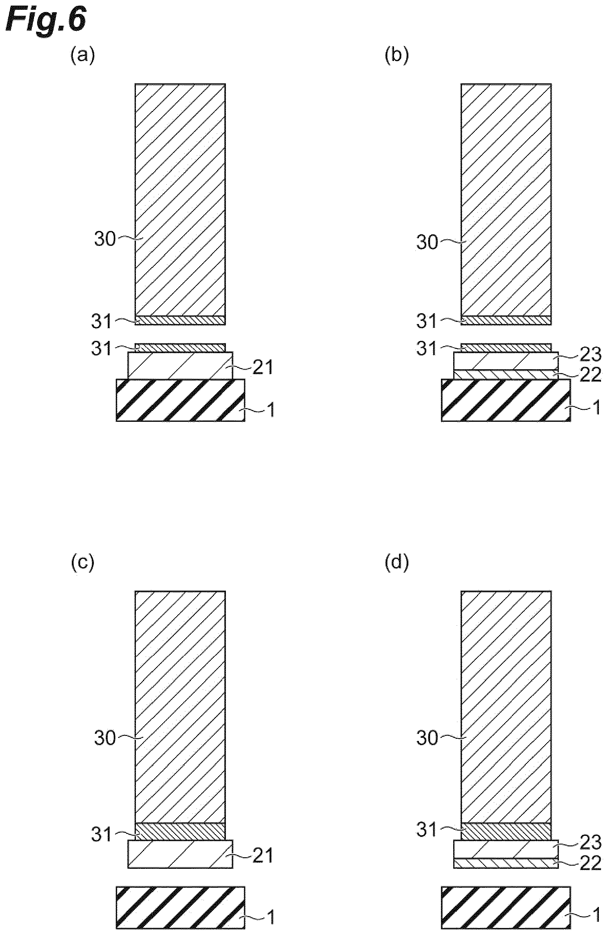

FIG. 5 is a graph showing the measurement results on the adhesive strength, and FIG. 6 is a cross-sectional view illustrating the fracture position of the test piece. The test pieces of Examples 1 to 18 exhibited an adhesive strength higher than 20 MPa, were all fractured at the position of the epoxy adhesive 31 as illustrated in FIGS. 6(a) and 6(b), but were not fractured by interfacial peeling between the ceramic substrate 1 and the metal layer 21. On the other hand, the test pieces of Comparative Examples 1 to 6 exhibited a low adhesive strength of 10 MPa and were fractured by interfacial peeling between the ceramic substrate 1 and the metal layer 21 or 22 as illustrated in FIGS. 6(c) and 6(d).

### Heat cycle test

The test pieces of Examples 1 to 18 which exhibited favorable adhesion were subjected to a heat cycle test of 1000 cycles when the test piece was "left to stand in an environment of 180°C for 30 minutes and then left to stand in an environment of -45°C for 30 minutes" was taken as one cycle. Even after the heat cycle test, abnormality such as peeling off did not occur in the metal layer.

### Reference Signs List

1: ceramic substrate, 2, 2a, 2b: metal layer, 3: cold spray apparatus, 4: high pressure gas cylinder, 5a: first pressure regulator, 5b: second pressure regulator, 5c: third pressure regulator, 6: heater, 7: powder supply apparatus, 10: nozzle of spray gun, 21, 21a, 21b: single metal layer, 22a, 22b: first metal layer, 23a, 23b: second metal layer, 30: stud pin, 31: epoxy adhesive, 40, 41: test piece.

## Claims

1. A method for producing a ceramic circuit board (100; 101) including a ceramic substrate (1) and a metal layer (2, 2a, 2b) formed on the ceramic substrate (1) and containing aluminum and/or an aluminum alloy, the method comprising:
a step of forming the metal layer (2, 2a, 2b) in contact with the ceramic substrate (1) by spraying a metal powder after accelerating the metal powder to a velocity of from 250 to 1050 m/s as well as heating the metal powder to from 10°C to 270°C; and
a step of subjecting the ceramic substrate (1) and the metal layer (2, 2a, 2b) formed on the ceramic substrate (1) to a heat treatment in an inert gas atmosphere, wherein
the metal powder contains aluminum particles and/or aluminum alloy particles,
wherein the ceramic substrate (1) and the metal layer (2, 2a, 2b) are heated to from 400°C to 600°C in the step of subjecting the ceramic substrate (1) and the metal layer (2, 2a, 2b) to a heat treatment in an inert gas atmosphere.

2. The method according to claim 1, wherein
the metal layer (2, 2a, 2b) has a first metal layer (22a, 22b) and a second metal layer 23a, 23b, and
the step of forming the metal layer (2, 2a, 2b) includes:
forming the first metal layer (22a, 22b) on the ceramic substrate (1) by spraying the metal powder containing an aluminum alloy onto the ceramic substrate (1) after accelerating the metal powder to a velocity of from 250 to 1050 m/s as well as heating the metal powder to from 10°C to 270°C, and
forming the second metal layer (23a, 23b) on the first metal layer (22a, 22b) by spraying the metal powder containing aluminum particles onto the first metal layer (22a, 22b) after accelerating the metal powder to a velocity of from 250 to 1050 m/s as well as heating the metal powder to from 10°C to 270°C.

3. The method according to claim 2, wherein the aluminum alloy particles are aluminum-magnesium alloy particles, wherein a content of magnesium in the aluminum-magnesium alloy particles is 6.0% by mass or less with respect to a mass of the aluminum-magnesium alloy particles.

4. The method according to claim 2 or 3, wherein a thickness of the first metal layer (22a, 22b) is 100 µm or less.

5. The method according to any one of claims 1 to 4, wherein an average particle diameter of the metal powder is from 10 to 70 µm.

6. The method according to any one of claims 1 to 5, wherein the metal layer (2, 2a, 2b) having a pattern is formed on the ceramic substrate (1) by disposing a mask material covering a part of a surface of the ceramic substrate (1) on the ceramic substrate (1) in the step of forming the metal layer (2, 2a, 2b).

## Patentansprüche

1. Verfahren zur Herstellung einer keramischen Leiterplatte (100; 101), umfassend ein keramisches Substrat (1) und eine Metallschicht (2, 2a, 2b), die auf dem keramischen Substrat (1) ausgebildet ist und Aluminium und/oder eine Aluminiumlegierung enthält, wobei das Verfahren Folgendes umfasst:
einen Schritt des Ausbildens der Metallschicht (2, 2a, 2b) in Kontakt mit dem keramischen Substrat (1) durch Aufsprühen eines Metallpulvers nach Beschleunigung des Metallpulvers auf eine Geschwindigkeit von 250 bis 1050 m/s sowie Erhitzen des Metallpulvers auf 10 °C bis 270 °C; und
einen Schritt des Vomehmens einer Wärmebehandlung des keramischen Substrates (1) und der Metallschicht (2, 2a, 2b), die auf dem keramischen Substrat (1) ausgebildet ist, in einer Inertgasatmosphäre, wobei
das Metallpulver Aluminiumpartikel und/oder Aluminiumlegierungspartikel enthält,
wobei das keramische Substrat (1) und die Metallschicht (2, 2a, 2b) in dem Schritt des Vomehmens der Wärmebehandlung des keramischen Substrates (1) und der Metallschicht (2, 2a, 2b) in einer Inertgasatmosphäre auf 400 °C bis 600 °C erhitzt werden.

2. Verfahren nach Anspruch 1, wobei
die Metallschicht (2, 2a, 2b) eine erste Metallschicht (22a, 22b) und eine zweite Metallschicht (23a, 23b) aufweist und
der Schritt des Ausbildens der Metallschicht (2, 2a, 2b) Folgendes umfasst:
Ausbilden der ersten Metallschicht (22a, 22b) auf dem keramischen Substrat (1) durch Aufsprühen des Metallpulvers, das eine Aluminiumlegierung enthält, auf das keramische Substrat (1) nach Beschleunigung des Metallpulvers auf eine Geschwindigkeit von 250 bis 1050 m/s sowie Erhitzen des Metallpulvers auf 10 °C bis 270 °C und
Ausbilden der zweiten Metallschicht (23a, 23b) auf der ersten Metallschicht (22a, 22b) durch Aufsprühen des Metallpulvers, das Aluminiumpartikel enthält, auf die erste Metallschicht (22a, 22b) nach Beschleunigung des Metallpulvers auf eine Geschwindigkeit von 250 bis 1050 m/s sowie Erhitzen des Metallpulvers auf 10 °C bis 270 °C.

3. Verfahren nach Anspruch 2, wobei die Aluminiumlegierungspartikel Aluminium-Magnesium-Legierungspartikel sind, wobei ein Magnesiumgehalt in den Aluminium-Magnesium-Legierungspartikeln 6,0 Masse% oder weniger, bezogen auf eine Masse der Aluminium-Magnesium-Legierungspartikel, beträgt.

4. Verfahren nach Anspruch 2 oder 3, wobei eine Dicke der ersten Metallschicht (22a, 22b) 100 µm oder weniger beträgt.

5. Verfahren nach einem der Ansprüche 1 bis 4, wobei ein durchschnittlicher Partikeldurchmesser des Metallpulvers 10 bis 70 µm beträgt.

6. Verfahren nach einem der Ansprüche 1 bis 5, wobei die Metallschicht (2, 2a, 2b) mit einer Struktur durch Anordnen eines Maskenmaterials, das einen Teil einer Oberfläche des keramischen Substrates (1) abdeckt, auf dem keramischen Substrat (1) in dem Schritt des Ausbildens der Metallschicht (2, 2a, 2b), auf dem keramischen Substrat (1) ausgebildet wird.

## Revendications

1. Procédé de production d'une carte de circuit céramique (100 ; 101) incluant un substrat céramique (1) et une couche métallique (2, 2a, 2b) formée sur le substrat céramique (1) et contenant de l'aluminium et/ou un alliage d'aluminium, le procédé comprenant :
une étape de formation de la couche métallique (2, 2a, 2b) en contact avec le substrat céramique (1) par pulvérisation d'une poudre métallique après accélération de la poudre métallique à une vitesse de 250 à 1 050 m/s, ainsi que chauffage de la poudre métallique à une température de 10 °C à 270 °C ; et
une étape de soumission du substrat céramique (1) et de la couche métallique (2, 2a, 2b) formée sur le substrat céramique (1) à un traitement thermique dans une atmosphère de gaz inerte,
la poudre métallique contenant des particules d'aluminium et/ou des particules d'alliage d'aluminium,
le substrat céramique (1) et la couche métallique (2, 2a, 2b) étant portés à une température de 400 °C à 600 °C dans l'étape de soumission du substrat céramique (1) et de la couche métallique (2, 2a, 2b) à un traitement thermique dans une atmosphère de gaz inerte.

2. Procédé selon la revendication 1, dans lequel
la couche métallique (2, 2a, 2b) a une première couche métallique (22a, 22b) et une deuxième couche métallique (23a, 23b), et
l'étape de formation de la couche métallique (2, 2a, 2b) inclut :
la formation de la première couche métallique (22a, 22b) sur le substrat céramique (1) par pulvérisation de la poudre métallique contenant un alliage d'aluminium sur le substrat céramique (1) après accélération de la poudre métallique à une vitesse de 250 à 1 050 m/s, ainsi que chauffage de la poudre métallique à une température de 10 °C à 270 °C, et
la formation de la deuxième couche métallique (23a, 23b) sur la première couche métallique (22a, 22b) par pulvérisation de la poudre métallique contenant des particules d'aluminium sur la première couche métallique (22a, 22b) après accélération de la poudre métallique à une vitesse de 250 à 1 050 m/s, ainsi que chauffage de la poudre métallique à une température de 10 °C à 270 °C.

3. Procédé selon la revendication 2, dans lequel les particules d'alliage d'aluminium sont des particules d'alliage d'aluminium-magnésium, une teneur en magnésium dans les particules d'alliage d'aluminium-magnésium étant de 6,0 % en masse ou moins par rapport à une masse des particules d'alliage d'aluminium-magnésium.

4. Procédé selon la revendication 2 ou 3, dans lequel une épaisseur de la première couche métallique (22a, 22b) est de 100 µm ou moins.

5. Procédé selon l'une quelconque des revendications 1 à 4, dans lequel un diamètre de particule moyen de la poudre métallique est de 10 à 70 µm.

6. Procédé selon l'une quelconque des revendications 1 à 5, dans lequel la couche métallique (2, 2a, 2b) ayant un motif est formée sur le substrat céramique (1) par disposition d'un matériau de masquage couvrant une partie d'une surface du substrat céramique (1) sur le substrat céramique (1) dans l'étape de formation de la couche métallique (2, 2a, 2b).
